(19) **Europäisches Patentamt / European Patent Office / Office européen des brevets**

(11) **EP 2 989 447 B1**

(12) **EUROPEAN PATENT SPECIFICATION**

(45) Date of publication and mention
of the grant of the patent:
**13.12.2017 Bulletin 2017/50**

(51) Int Cl.:
*G01N 21/64* (2006.01)   *G01R 31/26* (2014.01)
*H01L 51/00* (2006.01)

(21) Application number: **13722324.4**

(22) Date of filing: **26.04.2013**

(86) International application number:
**PCT/EP2013/058730**

(87) International publication number:
**WO 2014/173453 (30.10.2014 Gazette 2014/44)**

(54) **METHOD OF DETERMINING THE POTENTIAL EFFICIENCY OF A SOLUTION-PROCESSABLE PHOTOVOLTAIC MATERIAL**

VERFAHREN ZUR BESTIMMUNG DER POTENZIELLEN EFFIZIENZ EINES LÖSUNGSVERARBEITBAREN FOTOVOLTAISCHEN MATERIALS

PROCÉDÉ DE DÉTERMINATION DE L'EFFICACITÉ POTENTIELLE D'UN MATÉRIAU PHOTOVOLTAÏQUE APTE À UN TRAITEMENT EN SOLUTION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**02.03.2016 Bulletin 2016/09**

(73) Proprietor: **Bayerisches Zentrum für angewandte Energieforschung e.V.**
**91058 Erlangen (DE)**

(72) Inventors:
• **BARAN, Derya**
**06370 Batikent, Ankara (TR)**
• **BRABEC, Christoph J.**
**A-4040 Linz (AT)**

(74) Representative: **Dr. Gassner & Partner mbB**
**Marie-Curie-Str. 1**
**91052 Erlangen (DE)**

(56) References cited:
**US-A1- 2012 248 335     US-A1- 2013 098 449**

• **WENJIN YUE ET AL: "CuInS2 quantum dots synthesized by a solvothermal route and their application as effective electron acceptors for hybrid solar cells", JOURNAL OF MATERIALS CHEMISTRY, vol. 20, no. 35, 1 January 2010 (2010-01-01), page 7570, XP055073285, ISSN: 0959-9428, DOI: 10.1039/c0jm00611d**

• **SANG GUANGYI ET AL: "All-polymer solar cells based on a blend of poly[3-(10-n-octyl-3-phenothiazine-vinylene)thiophene-co-2,5-thiophene] and poly[1,4-dioctyloxyl-p-2,5-dicyanophenylenevinylene]", APPLIED PHYSICS LETTERS, AMERICAN INSTITUTE OF PHYSICS, US, vol. 94, no. 19, 12 May 2009 (2009-05-12), pages 193302-193302, XP012121272, ISSN: 0003-6951, DOI: 10.1063/1.3134490**

• **VEENSTRA S C ET AL: "Solar cells based on a polymer blend with a maximum external quantum efficiency of 52% and a power conversion efficiency of 1.5%", PROCEEDINGS OF THE SPIE - THE INTERNATIONAL SOCIETY FOR OPTICAL ENGINEERING SPIE - THE INTERNATIONAL SOCIETY FOR OPTICAL ENGINEERING USA, vol. 5938, 2005, pages 593815-1, XP055098286, ISSN: 0277-786X**

• **BONNER ET AL: "Measurement of the optical properties of donor and acceptor derivatized PPV block copolymers", PROCEEDINGS OF SPIE, vol. 4991, 7 July 2003 (2003-07-07), pages 452-459, XP055098289, ISSN: 0277-786X, DOI: 10.1117/12.479016**

- YU G ET AL: "Charge separation and photovoltaic conversion in polymer composites with internal donor/acceptor heterojunctions", JOURNAL OF APPLIED PHYSICS, AMERICAN INSTITUTE OF PHYSICS, 2 HUNTINGTON QUADRANGLE, MELVILLE, NY 11747, vol. 78, no. 7, 1 October 1995 (1995-10-01), pages 4510-4515, XP002102233, ISSN: 0021-8979, DOI: 10.1063/1.359792

- PIERRE ADRIEN ET AL: "Empirically based device modeling of bulk heterojunction organic photovoltaics", JOURNAL OF APPLIED PHYSICS, AMERICAN INSTITUTE OF PHYSICS, 2 HUNTINGTON QUADRANGLE, MELVILLE, NY 11747, vol. 113, no. 15, 21 April 2013 (2013-04-21), pages 154506-154506, XP012172410, ISSN: 0021-8979, DOI: 10.1063/1.4801662 [retrieved on 2013-04-19]

**Description**

The invention concerns a method of determining the potential efficiency of a solution-processable photovoltaic material.

According to the prior art there are known solution-processable photovoltaic materials, e. g. organic photovoltaic materials. Such materials are able to convert light into electricity. When developing a new organic photovoltaic material there have to be optimized several parameters. An important parameter which strongly influences the power conversion efficiency is the donor/acceptor (D/A) ratio. Further, the power conversion efficiency depends on the kind of solution or solvent, respectively, which is used for processing the photovoltaic material.

In order to determine the potential efficiency of a new photovoltaic material it is necessary to manufacture a photoelectric device and then to measure the electric output thereof. This is time consuming, burdensome and expensive.

Pierre Adrien et al: "Empirically based device modeling of bulk heterojunction organic photovoltaics", Journal of Applied Physics, American Institute of Physics, vol. 113, no. 15, 21 April 2013, pages 154506-154506 discloses a method of determining the potential efficiency of a solution-processable photovoltaic material to convert light into electricity, the method comprising the steps of providing (a) the photovoltaic material being a mixture comprising a predetermined ratio of a donor component and an acceptor component as such or the acceptor component as such; making a first luminescence spectrum of the donor component or the acceptor component; making a second luminescence spectrum of the photovoltaic material; and normalizing the intensity values of the first luminescence spectrum, thereby obtaining a calculated first photoluminescence spectrum.

Wenjin Yue et al: "CuInS2 quantum dots synthesized by a solvothermal route and their application as effective electron acceptors for hybrid solar cells", Journal of Materials Chemistry, vol. 20, no. 35, 1 January 2010, page 7570 discloses the calculation of the ratio between the maximum photoluminescence of the material and the maximum photoluminescence of pristine materials. The thereby achieved "quenching ratio" is used to describe charge-transfer photovoltaic performance.

It is an object of the present invention to overcome the disadvantages in the art. According to a goal of the invention there shall be provided a method which allows in particular a fast, simple and cheap determination of the potential efficiency of a solution-processable photovoltaic material.

This object is solved by the features of claim 1. Embodiments of the invention are described by the features of claims 2 to 11.

According to the present invention there is proposed a method of determining the potential efficiency of a solution-processable photovoltaic material to convert light into electricity, the method comprising the steps of claim 1.

In the context of the present invention under the term "potential efficiency" there is understood the suitability of a material to be used as a photovoltaic material. The potential efficiency to convert light into electricity can in particular be described by the power conversion efficiency of the material. Under "corresponding values" there are understood values which correspond to the same wavelength.

In terms of the present invention it has to be noted that in order to calculate the figure of merit the first intensity value can be divided through the second intensity value and vice versa.

The proposed method allows to determine the potential efficiency of a solution-processable photovoltaic material to convert light into electricity simply on basis of luminescence measurements and by using the proposed figure of merit. Inventors surprisingly found that a ratio of the intensity of the singlet emission $I_{S1-S0}$ of the donor component or the acceptor component of the material and the intensity of the charge transfer emission $I_{CT}$ of the material relates to the potential efficiency of the material to convert light into electricity. The proposed figure of merit allows qualitatively to determine e. g. the optimal D/A ratio in a new material to be tested. Further, an optimal solution to process such a new material can be easily identified. Moreover, the influence of additives or the like can be determined.

The solution-processable photovoltaic material may be in particular an organic material.

According to the invention, the first and the second luminescence spectra are photoluminescence spectra. A photoluminescence spectrum results from the measurement of photoluminescence intensity above the wavelength thereof. Photoluminescence spectroscopy provides information about radiative recombination. Photoluminescence spectra can be made without big effort by using samples which can be prepared fast and simple.

When using photoluminescence spectra to determine the potential efficiency of the solution-processable photovoltaic material to convert light into electricity the first photoluminescence spectrum may be a "calculated first photoluminescence spectrum". In the calculated first photoluminescence spectrum the intensity values are normalized values. In order to carry out the normalization it is determined which wavelength corresponds e. g. to a maximum intensity value of the first photoluminescence spectrum. Then there is taken at the same wavelength the corresponding intensity value from the second photoluminescence spectrum. Then the maximum intensity value taken from the first photoluminescence spectrum divided through the corresponding intensity value taken from the second photoluminescence spectrum, the division resulting in a correction value. The calculated first photoluminescence spectrum results from a division of the intensity values of the first photoluminescence spectrum through the correction value.

According to the invention the method comprises the further step of calculating a third photoluminescence spectrum by subtracting from the second photoluminescence the calculated first photoluminescence spectrum. - The second photoluminescence spectrum, which is recorded from the photovoltaic material represents the charge transfer emission $I_{CT}$. It mostly further comprises also emissions resulting from singlet emission $I_{S1-S0}$ of the donor or the acceptor component. When subtracting from the second photoluminescence spectrum the calculated first photoluminescence spectrum, the resulting third photoluminescence spectrum shows essentially just the contribution of the charge transfer emission $I_{CT}$ of the material.

When calculating the figure of merit on basis of photoluminescence spectra the third photoluminescence spectrum is taken instead of the second luminescence spectrum. I. e. in order to calculate the figure of merit when using photoluminescence spectra there is formed a ratio between the first intensity value and the corresponding second intensity value each being taken from a maximum region of the respective calculated first and third photoluminescence spectra.

In particular when calculating the figure of merit on basis of photoluminescence spectra the method may comprise the further steps of

preparing a first sample by depositing a layer of the donor component or the acceptor component on a substrate; and

preparing a second sample by depositing a layer of the photovoltaic material on a further substrate.

The steps of preparing samples for making the photoluminescence spectra can be carried out fast and simply. In order to make the photoluminescence spectra it is not necessary to prepare from the photovoltaic material to be tested a photovoltaic device having electrical contacts and the like. The simple and fast preparation of the samples makes it possible to use the proposed method for screening a large number of samples with respect to their potential efficiency to convert light into electricity.

When preparing the samples it is possible that the layer is deposited on the substrate or the further substrate by one of the following methods: spin coating, doctor blade coating, spraying dipping, dropping, printing, ink-jet printing. Some of the aforementioned methods can be easily automated.

According to a further aspect of the invention there is provided a method of screening the potential efficiency of the plurality of solution-processable photovoltaic materials, the method comprising the following steps:

making a plurality of samples of the photovoltaic material having a different ratio of the donor and the acceptor component and being processed with the same solution, and

using the method according to the invention to determine the figure of merit of each sample in order to identify the material having the highest potential efficiency.

According to a further aspect of the invention there is provided a method of screening the potential efficiency of a plurality of solution-processable photovoltaic materials, the method comprising the following steps:

making a plurality of samples of the photovoltaic material having the same ratio of the donor and the acceptor component and being processed with different solutions, and

using the method according to the present invention to determine the figure of merit of each sample in order to identify the material having the highest potential efficiency.

This method allows to identify an optimal solution for making an efficient photovoltaic material.

According to a further aspect of the invention there is proposed a method of screening the potential efficiency of a plurality of solution-processable photovoltaic materials, the method comprising the following steps:

making a plurality of samples of the photovoltaic material having the same ratio of the donor and the acceptor component, wherein the donor or the acceptor component is varied, and the samples being processed with the same solution, and

using the method according to the present invention to determine the figure of merit of each sample in order to identify the material having the highest potential efficiency.

By the proposed method it can be determined which kind of donor and acceptor material form promising combinations in order to make a material with a high potential efficiency.

Advantageously the preparation of at least one of the first or second sample may be performed automatically by a robot. In order to further enhance the screening methods the first and/or second samples may be automatically loaded into and unloaded from a device for making luminescence spectra. I. e. all method steps starting from the preparation of the samples and ending up with the making of luminescence spectra may be carried out automatically.

Further, the photoluminescence spectra may be automatically processed by a computer to produce the figure of merit. I. e. also the figure of merit may be automatically calculated. Hence, the proposed method may result in a proposal of materials having a high potential efficiency. The proposed method sharply increases the velocity in finding new photovoltaic materials having a high potential efficiency to convert light into electricity.

Embodiments of the invention are now described with reference to the enclosed figures in which

Fig. 1    shows a first photoluminescence spectrum of a pristine donor component,

Fig. 2    shows second photoluminescence spectra of materials having different D/A ratios,

Fig. 3    shows calculated first photoluminescence spectra of the contribution of the donor components for the materials shown in Fig. 2,

Fig. 4    shows third photoluminescence spectra resulting of a subtraction of the calculated first photoluminescence spectra from the respective second photoluminescence spectra,

Fig. 5    shows a first figure of merit above the donor/acceptor ratio in comparison to the power conversion efficiency,

Fig. 6    shows the first figure of merit above the power conversion efficiency,

Fig. 7    shows a first electroluminescence spectrum of the pristine donor component,

Fig. 8    shows second electroluminescence spectra of materials having different A/D ratios and

Fig. 9    shows a second figure of merit above the donor/acceptor ratio in comparison to the power conversion efficiency.

The spectra shown in the figures were measured by using samples which contain as donor component D a polycarbazole derivative, namely poly[[9-(1-octylnonyl)-9H-carbazole-2,7-diyl]-2,5-thiophenediyl-2,1,3-benzothiadiazole-4,7-diyl-2,5-thiophenediyl] (PCDTBT) and as acceptor component A [6,6]-phenyl-$C_{61}$-butyric acid methyl ester ($PC_{60}BM$).

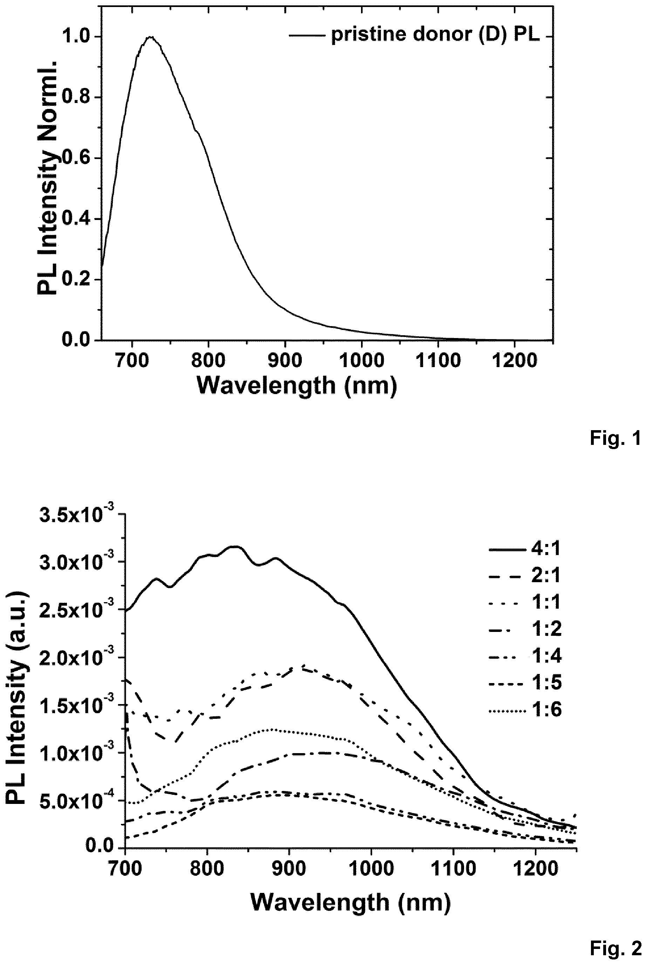

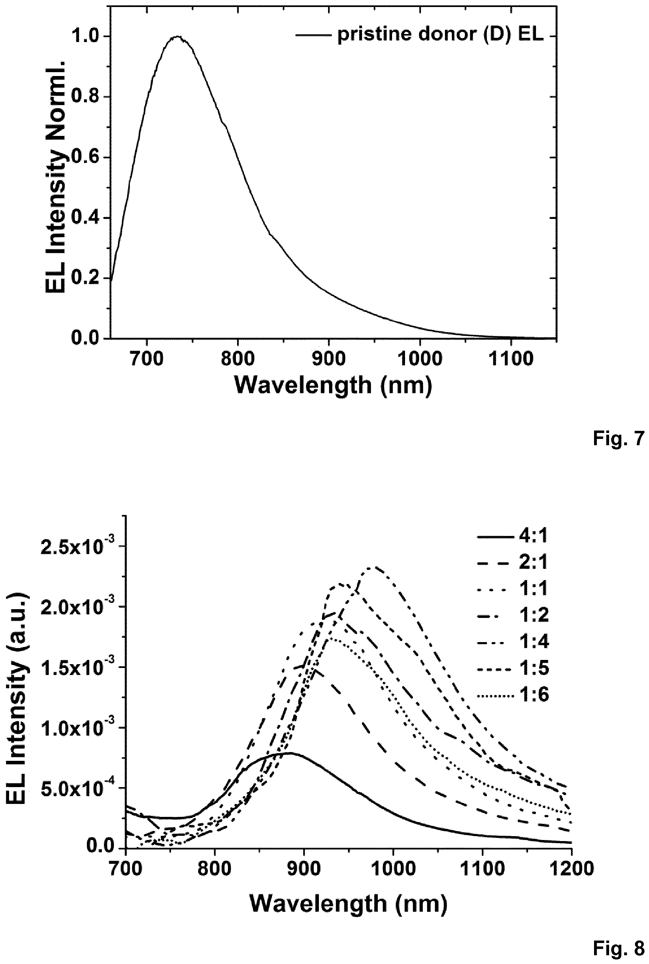

The spectra shown in Figs. 2 and 8 were made by using materials having different weight ratios D:A of 4:1, 2:1, 1:1, 1:2, 1:4, 1:5 and 1:6, respectively.

In order to prepare the samples for photoluminescence measurements there was made a solution of the respective material with a concentration of 7 mg/ml. As solvent there was used chlorobenzene (CB).

Photoluminescence measurements were performed on layers which were excited by an Argon laser at 488 nm. The photoluminescence emission of the layers was dispersed by a 600 lines/mm grating monochromator (HRS-2) and detected by a Germanium (Ge) detector (ADC 403L) through the lock-in technique. The photoluminescence spectrum was corrected for the optical density of the sample at the excitation wavelength, and for the detection sensitivity of the Ge detector.

Figs. 1 to 6 refer to a method of determining a first figure of merit $FOM_{PL}$ according to the present invention by using photoluminescence measurements.

Fig. 1 shows a first photoluminescence spectrum of the pristine donor component D. The spectrum exhibits a maximum at a wavelength of around 730 nm. The maximal intensity results from the singlet transmission $I_{S1-S0}$.

Fig. 2 show second photoluminescence spectra of photovoltaic materials having different D/A ratios. As can be seen from Fig. 2 the material having a D/A ratio of 4:1 shows the highest photoluminescence intensity. The emissions of the photoluminescence spectra shown in Fig. 2 result from singlet transmissions $I_{S1-S0}$ as well as charge transfer emissions $I_{CT}$.

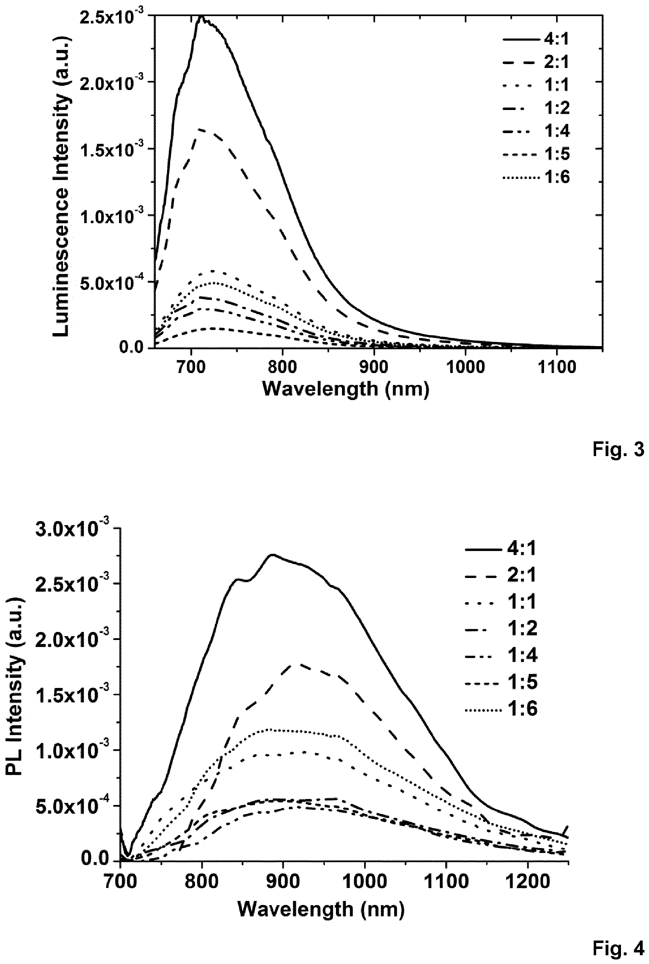

Fig. 3 shows for the materials having the different D/A ratios the contributions of the singlet emissions $I_{S1-S0}$. The shown "calculated first photoluminescence spectra" were calculated on basis of the first and second photoluminescence spectra. Fig. 4 shows third photoluminescence spectra for the materials having the different D/A ratios. The third photoluminescence spectra result from a subtraction of the calculated first photoluminescence spectra shown in Fig. 3 from the second photoluminescence spectra shown in Fig. 2. The third photoluminescence spectra represent just the contribution of the charge transfer emission $I_{CT}$ of the tested materials. The first figure of merit $FOM_{PL}$ is calculated on basis of the results shown in Figs. 3 and 4, e. g. by the following equation:

$$FOM_{PL} = (I_{max,\ CT}/I_{max,\ S1-S0})$$

wherein

$I_{max, CT}$ is the maximum intensity of the respective spectra taken from Fig. 4, and $I_{max, S1-S0}$ is the maximum intensity taken from the respective spectra of Fig. 3. Outside the scope of the present invention, instead of the above mentioned maximum intensities of the respective spectra there can also be used corresponding intensities taken from a maximum region of the respective spectra.

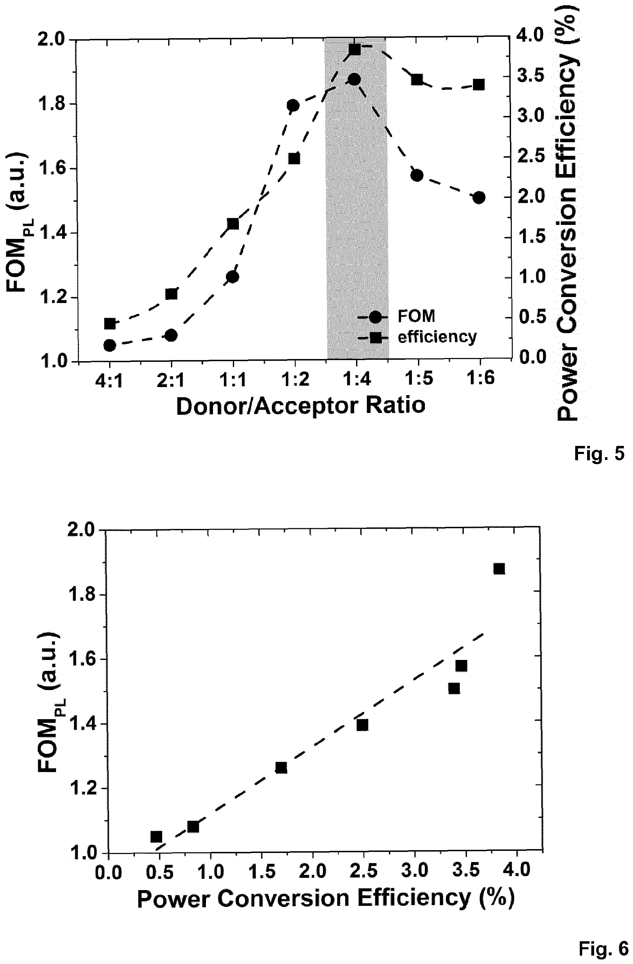

Fig. 5 depicts a plot showing the first figure of merit $FOM_{PL}$ above the D/A ratio. Further, Fig. 5 shows the power conversion efficiency in percent above the D/A ratio. From the results shown in Fig. 5 one can see that the first figure of merit $FOM_{PL}$ strongly correlates with the power conversion efficiency. Consequently, from the figure of merit according to the present invention one can determine the potential efficiency of a solution-processable photovoltaic material.

Fig. 6 shows the relation between the first figure of merit $FOM_{PL}$ and the power conversion efficiency. Also from Fig. 6 one can see that there exists an excellent correlation between the first figure of merit $FOM_{PL}$ and the power conversion efficiency.

Figs. 7 to 9 refer to a second embodiment of the method in which a second figure of merit $FOM_{EL}$ was calculated on basis of results of electroluminescence measurements.

In order to carry out electroluminescence measurements as samples fully functional photovoltaic devices were prepared. The photovoltaic devices were elaborated using PCDTBT (received from 1-material and triply purified by chromatography) as electron donor and $PC_{60}BM$ (Solenne) as electron acceptor. The standard device structure was as follows: ITO/PEDOT:PSS (AL4083)/PCDTBT:$PC_{60}BM$/Ca/Ag, wherein ITO means "indium-doped tin oxide" and PEDOT:PSS means "poly(3,4-ethylenedioxythiophene)-poly(styrenesulfonate)". ITO coated glass with a surface resistance lower than 10 $\Omega$/sq (Osram) was used as transparent electrode. ITO was cleaned by ultrasonic treatment with acetone and isopropyl alcohol and dried under a flow of dry nitrogen. A PEDOT:PSS (AL4083, Heraeus) solution diluted in Isopropanol was doctor-bladed onto clean substrates, resulting in a thickness of approximately 40 nm as determined with Dektak profilometer. PEDOT:PSS layer was annealed from 10 min at 140°C. The PCDTBT (7 mg/ml) was blended with $PC_{60}BM$ in the following stoichiometric PCDTBT:$PC_{60}BM$ ratios 4:1, 2:1, 1:1, 1:2, 1:4, 1:5 and 1:6 and the solutions were stirred at 65°C for 12 h. The layers were doctor-bladed from CB solution onto PEDOT:PSS layer. Thickness of the layers were kept constant around 80-90 nm measured with profilometer. A Ca/Ag ($\sim$ 20/80 nm) top electrode was evaporated via a mask in vacuum onto the active layers with an electrode area of 0.104 $cm^2$. Power conversion efficiency (PCE) was calculated from J-V characteristics recorded with Botest source measure unit by an Oriel Sol1A 94061 solar simulator with an intensity of 100 mW/$cm^2$ where the light intensity was calibrated with a standard silicon photodiode.

The electroluminescence measurements were performed by applying a forward bias (250 mA/$cm^2$) supplied by an external current/voltage source through the devices which have an active area of 0.104 $cm^2$. The emitted light was then collected by an monochromator and detected by liquid-nitrogen-cooled Ge detector. The spectrum was recorded by a standard lock-in technique. The system was wavelength calibrated.

Fig. 7 shows a first electroluminescence spectra of the pristine donor component D.

Fig. 8 shows a second electroluminescence spectra of materials having different D/A ratios.

The second figure or merit $FOM_{EL}$ was calculated by using the above equation.

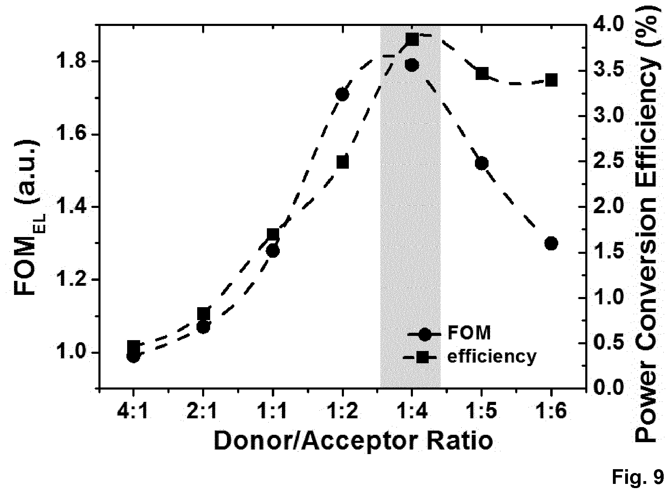

From Fig. 9 one can see that the second figure of merit $FOM_{EL}$ calculated on basis of electroluminescence spectra again exhibits an excellent correlation with the power conversion efficiency.

The results achieved by use of electroluminescence measurements confirm the results achieved by the use of photoluminescence spectra. Hence, both methods produce a figure of merit which has an excellent correlation to the power conversion efficiency.

The results of both methods are again summarized by the following table:

| Ratio (D:A) | $I_{CTPL}$ max (nm)[a] | $FOM_{PL}$ ($I_{CT}/I_{S1-S0}$)[b] | $I_{CTEL}$ max (cm)[c] | $FOM_{EL}$ ($I_{CT}/I_{S1-S0}$)[b] | PCE (%)[d] |
|---|---|---|---|---|---|
| 4:1 | 886 | 1.05 | 875 | 0.99 | 0.47 |
| 2:1 | 914 | 1.08 | 897 | 1.07 | 0.83 |
| 1:1 | 917 | 1.26 | 920 | 1.28 | 1.70 |
| 1:2 | 925 | 1.79 | 932 | 1.71 | 3.43 |
| 1:4 | 938 | 1.87 | 978 | 1.79 | 3.85 |
| 1:5 | 896 | 1.57 | 940 | 1.52 | 3.47 |
| 1:6 | 881 | 1.49 | 927 | 1.30 | 3.41 |
| [a] Determined from PL spectra, [b] Calculated from $I_{CT}/I_{S1-S0}$, [c] Determined from EL spectra, [d] Derived from J-V curves of the devices. | | | | | |

The power conversion efficiencies shown in Figs. 5 and 9 were derived from J-V curves of devices prepared for electroluminescence measurements.

**Claims**

1.  A method of determining the potential efficiency of a solution-processable photovoltaic material to convert light into electricity, the method comprising the steps of

    providing (a) the photovoltaic material (DA) being a mixture comprising a predetermined ratio of a donor component (D) and an acceptor component (A), and (b1) the donor component (D) as such or (b2) the acceptor component (A) as such;

    making a first photoluminescence spectrum of the donor component or the acceptor component;

    making a second photoluminescence spectrum of the photovoltaic material (DA); normalizing the intensity values of the first photoluminescence spectrum, thereby obtaining a calculated first photoluminescence spectrum, whereby the normalization includes the following steps:

    a) determining which wavelength corresponds to a maximum intensity value of the first photoluminescence spectrum,

    b) taking at the same wavelength the corresponding intensity value from the second photoluminescence spectrum,

    c) dividing the maximum intensity value taken from the first photoluminescence spectrum through the corresponding intensity value taken from the second photoluminescence spectrum, the division resulting in a correction value,

    d) dividing the intensity values of the first photoluminescence spectrum through the correction value to obtain the calculated first photoluminescence spectrum;

    calculating a third photoluminescence spectrum by subtracting from the second photoluminescence spectrum the calculated first photoluminescence spectrum; calculating a figure of merit $FOM_{PL}$ by forming a ratio between a first intensity value of luminescence of the calculated first photoluminescence spectrum and a second intensity value of luminescence of the third photoluminescence spectrum,

    wherein the calculated first photoluminescence spectrum shows the contribution of the singlet emission $I_{S1-S0}$ and wherein the first intensity value is the maximum intensity $I_{max,\,S1-S0}$ of the calculated first photoluminescence spectrum,

    wherein the third photoluminescence spectrum represents the contribution of the charge transfer emission $I_{CT}$ and wherein the second intensity value is the maximum intensity $I_{max,\,CT}$ of the third photoluminescence spectrum, wherein the following equation is used:

    $$FOM_{PL} = (I_{max,\,CT}/I_{max,\,S1-S0}) \text{ or } FOM_{PL} = (I_{max,\,S1-S0}/I_{max,\,CT});$$

    and determining the potential efficiency of the photovoltaic material on basis of the figure of merit $FOM_{PL}$.

2.  The method of claim 1, wherein the solution-processable photovoltaic material is an organic material.

3.  The method of one of the preceding claims, comprising the further steps of :

    preparing a first sample by depositing a layer of the donor component (D) or the acceptor component (A) on a substrate; and

    preparing a second sample by depositing a layer of the photovoltaic material (DA) on a further substrate.

4.  The method of claim 3, wherein the layer is deposited on the substrate or the further substrate by one of the following methods: spin coating, doctor blade coating, spraying, dipping, dropping, printing, ink-jet printing.

5.  A method of screening the potential efficiency of a plurality of solution-processable photovoltaic materials, the method comprising the following steps:

    making a plurality of samples of the photovoltaic material having a different ratio of the donor and the acceptor component and being processed with the same solution, and
using the method of one of the preceding claims to determine the figure of merit FOM$_{PL}$ of each sample in order to identify the material having the highest potential efficiency.

6. A method of screening the potential efficiency of a plurality of solution-processable photovoltaic materials, the method comprising the following steps:

making a plurality of samples of the photovoltaic material having the same ratio of the donor and the acceptor component and being processed with different solutions, and
using the method of one claims 1 to 4 to determine the figure of merit FOM$_{PL}$ of each sample in order to identify the material having the highest potential efficiency.

7. A method of screening the potential efficiency of a plurality of solution-processable photovoltaic materials, the method comprising the following steps:

making a plurality of samples of the photovoltaic material having the same ratio of the donor and the acceptor component, wherein the donor or the acceptor component is varied, and the samples being processed with the same solution, and
using the method of one of the claims 1 to 4 to determine the figure of merit FOM$_{PL}$ of each sample in order to identify the material having the highest potential efficiency.

8. The method of one of claims 5 to 7, wherein the preparation of at least one of the first or second sample is performed automatically by a robot.

9. The method of one of claims 5 to 8, wherein the first and/or second samples are automatically loaded into and unloaded from a device for making luminescence spectra.

10. The method of one of claims 5 to 9, wherein the photoluminescence spectra are automatically processed by a computer to produce the figure of merit FOM$_{PL}$.

**Patentansprüche**

1. Verfahren zur Bestimmung des potentiellen Wirkungsgrads eines lösungsverarbeitbaren photovoltaischen Materials zur Umwandlung von Licht in Elektrizität, wobei das Verfahren die folgenden Schritte umfasst:

Bereitstellen (a) des photovoltaischen Materials (DA), das ein Gemisch ist, aufweisend ein vorbestimmtes Verhältnis einer Donorkomponente (D) und einer Akzeptorkomponente (A), und (b1) die Donorkomponente (D) als solche oder (b2) die Akzeptorkomponente (A) als solche;
Herstellen eines ersten Photolumineszenzspektrums der Donorkomponente oder der Akzeptorkomponente;
Herstellen eines zweiten Photolumineszenzspektrums des photovoltaischen Materials (DA);
Normalisieren der Intensitätswerte des ersten Photolumineszenzspektrums und dadurch Erhalten eines berechneten ersten Photolumineszenzspektrums, wobei das Normalisieren die folgenden Schritte umfasst:

a) Bestimmen, welche Wellenlänge einem maximalen Intensitätswert des ersten Photolumineszenzspektrums entspricht,
b) Entnehmen, bei der gleichen Wellenlänge, des entsprechenden Intensitätswerts aus dem zweiten Photolumineszenzspektrum,
c) Dividieren des maximalen Intensitätswerts aus dem ersten Photolumineszenzspektrum durch den entsprechenden Intensitätswert aus dem zweiten Photolumineszenzspektrum, wobei die Division einen Korrekturwert ergibt,
d) Dividieren der Intensitätswerte des ersten Photolumineszenzspektrums durch den Korrekturwert, um das berechnete erste Photolumineszenzspektrum zu erhalten;

Berechnen eines dritten Photolumineszenzspektrums durch Subtrahieren des berechneten ersten Photolumineszenzspektrums von dem zweiten Photolumineszenzspektrum;
Berechnen einer Merit-Zahl FOM$_{PL}$ durch Bilden eines Verhältnisses zwischen einem ersten Lumineszenz-Intensitätswert des berechneten ersten Photolumineszenzspektrums und einem zweiten Lumineszenz-Intensitätswert des dritten Photolumineszenzspektrums,
wobei das berechnete erste Photolumineszenzspektrum den Beitrag der Singulett-Emission $I_{S1-S0}$ zeigt und wobei der erste Intensitätswert die maximale Intensität $I_{max, S1-S0}$ des berechneten ersten Photolumineszenzspektrums ist,
wobei das dritte Photolumineszenzspektrum den Beitrag der Ladungstransferemission $I_{CT}$ darstellt und wobei der zweite Intensitätswert die maximale Intensität $I_{max, CT}$ des dritten Photolumineszenzspektrums ist,
wobei die folgende Gleichung verwendet wird:

$$FOM_{PL} = (I_{max, CT}/I_{max, S1-S0}) \text{ oder } FOM_{PL} = (I_{max, S1-S0}/I_{max, CT});$$

und
Bestimmen des potentiellen Wirkungsgrads des photovoltaischen Materials auf Basis der Merit-Zahl $FOM_{PL}$.

2. Verfahren nach Anspruch 1, wobei das lösungsverarbeitbare photovoltaische Material ein organisches Material ist.

3. Verfahren nach einem der vorangehenden Ansprüche, umfassend die weiteren folgenden Schritte:

   Herstellen einer ersten Probe durch Abscheiden einer Schicht der Donorkomponente (D) oder der Akzeptorkomponente (A) auf einem Substrat; und
   Herstellen einer zweiten Probe durch Abscheiden einer Schicht des photovoltaischen Materials (DA) auf einem weiteren Substrat.

4. Verfahren nach Anspruch 3, wobei die Schicht auf dem Substrat oder dem weiteren Substrat durch eines der folgenden Verfahren abgeschieden wird: Spin-Coating, Rakelbeschichten, Sprühen, Tauchen, Tropfen, Drucken, Tintenstrahldrucken.

5. Verfahren zum Screening des potentiellen Wirkungsgrads einer Vielzahl von lösungsverarbeitbaren photovoltaischen Materialien, wobei das Verfahren die folgenden Schritte umfasst:

   Herstellen einer Vielzahl von Proben des photovoltaischen Materials mit einem unterschiedlichen Verhältnis der Donor- und der Akzeptorkomponente, die mit der gleichen Lösung verarbeitet werden, und
   Verwenden des Verfahrens nach einem der vorangehenden Ansprüche zur Bestimmung der Merit-Zahl $FOM_{PL}$ einer jeden Probe, um das Material mit dem höchsten potentiellen Wirkungsgrad zu erkennen.

6. Verfahren zum Screening des potentiellen Wirkungsgrads einer Vielzahl von lösungsverarbeitbaren photovoltaischen Materialien, wobei das Verfahren die folgenden Schritte umfasst:

   Herstellen einer Vielzahl von Proben des photovoltaischen Materials mit dem gleichen Verhältnis der Donor- und der Akzeptorkomponente, die mit unterschiedlichen Lösungen verarbeitet werden, und
   Verwenden des Verfahrens nach einem der Ansprüche 1 bis 4 zur Bestimmung der Merit-Zahl $FOM_{PL}$ einer jeden Probe, um das Material mit dem höchsten potentiellen Wirkungsgrad zu erkennen.

7. Verfahren zum Screening des potentiellen Wirkungsgrads einer Vielzahl von lösungsverarbeitbaren photovoltaischen Materialien, wobei das Verfahren die folgenden Schritte umfasst:

   Herstellen einer Vielzahl von Proben des photovoltaischen Materials mit dem gleichen Verhältnis der Donor- und der Akzeptorkomponente, wobei die Donor- oder die Akzeptorkomponente variiert wird und die Proben mit der gleichen Lösung verarbeitet werden, und
   Verwenden des Verfahrens nach einem der Ansprüche 1 bis 4 zur Bestimmung der Merit-Zahl $FOM_{PL}$ einer jeden Probe, um das Material mit dem höchsten potentiellen Wirkungsgrad zu erkennen.

8. Verfahren nach einem der Ansprüche 5 bis 7, wobei die Herstellung der ersten und/oder der zweiten Probe automatisch durch einen Roboter durchgeführt wird.

9. Verfahren nach einem der Ansprüche 5 bis 8, wobei die erste und/oder die zweite Probe automatisch in und aus der Vorrichtung zur Herstellung von Lumineszenzspektren geladen werden.

**10.** Verfahren nach einem der Ansprüche 5 bis 9, wobei die Photolumineszenzspektren automatisch durch einen Computer verarbeitet werden, um die Merit-Zahl FOM$_{PL}$ zu erzeugen.

**Revendications**

**1.** Procédé de détermination de l'efficacité potentielle d'un matériau photovoltaïque apte à un traitement en solution afin de convertir la lumière en électricité, le procédé comprend les étapes consistant à

fournir (a) le matériau photovoltaïque (DA) sous forme de mélange comprenant un rapport prédéfini d'un composant donneur (D) et d'un composant accepteur (A) et (b1) le composant donneur (D) en tant que tel ou (b2) le composant accepteur (A) en tant que tel;

réaliser un premier spectre de photoluminescence du composant donneur ou du composant accepteur;

réaliser un deuxième spectre de photoluminescence du matériau photovoltaïque (DA);

normaliser les valeurs d'intensité du premier spectre de photoluminescence, obtenant ainsi un premier spectre de photoluminescence calculé, en ce que la normalisation comprend les étapes suivantes consistant à:

a) déterminer la longueur d'onde qui correspond à une valeur d'intensité maximale du premier spectre de photoluminescence,

b) prendre à la même longueur d'onde la valeur d'intensité correspondante à partir du deuxième spectre de photoluminescence,

c) diviser la valeur d'intensité maximale prise à partir du premier spectre de photoluminescence par la valeur d'intensité correspondante prise à partir du deuxième spectre de photoluminescence, la division résultant en une valeur de correction,

d) diviser les valeurs d'intensité du premier spectre de photoluminescence par la valeur de correction afin d'obtenir le premier spectre de photoluminescence calculé;

calculer un troisième spectre de photoluminescence en soustrayant du deuxième spectre de photoluminescence le premier spectre de photoluminescence calculé;

calculer un facteur de qualité FOM$_{PL}$ par la formation d'un rapport entre une première valeur d'intensité de luminescence du premier spectre de photoluminescence calculé et une seconde valeur d'intensité de luminescence du troisième spectre de photoluminescence,

en ce que le premier spectre de photoluminescence calculé indique la contribution de l'émission singulet I$_{S1-S0}$ et en ce que la première valeur d'intensité est l'intensité maximale I$_{max, S1-S0}$ du premier spectre de photoluminescence calculé,

en ce que le troisième spectre de photoluminescence représente la contribution de l'émission de transfert de charge I$_{CT}$ et en ce que la seconde valeur d'intensité est l'intensité maximale I$_{max, CT}$ du troisième spectre de photoluminescence,

en ce que l'équation suivante est utilisée:

$$\text{FOM}_{PL} = (I_{max,\ CT}/I_{max,\ S1-S0})\ \text{ou}\ \text{FOM}_{PL} = (I_{max,\ S1-S0}/I_{max,\ CT});$$

et

déterminer l'efficacité potentielle du matériau photovoltaïque sur la base du facteur de qualité FOM$_{PL}$.

**2.** Procédé selon la revendication 1, en ce que le matériau photovoltaïque apte à un traitement en solution est un matériau organique.

**3.** Procédé selon l'une des revendications précédentes, comprenant les autres étapes consistant à:

préparer un premier échantillon en déposant une couche du composant donneur (D) ou du composant accepteur (A) sur un substrat; et

préparer un second échantillon en déposant une couche de matériau photovoltaïque (DA) sur un autre substrat.

**4.** Procédé selon la revendication 3, en ce que la couche est déposée sur le substrat ou sur l'autre substrat selon l'un des procédés suivants:

enduction centrifuge, enduction par racloir, par pulvérisation, par trempage, par goutte, par impression, par impression par jet d'encre.

5. Procédé de détection de l'efficacité potentielle d'une pluralité de matériaux photovoltaïques aptes à un traitement en solution, le procédé comprend les étapes suivantes consistant à:

réaliser une pluralité d'échantillons du matériau photovoltaïque ayant un rapport différent du composant donneur et accepteur et étant traités avec la même solution, et
utiliser le procédé de l'une des revendications précédentes pour déterminer le facteur de qualité $FOM_{PL}$ de chaque échantillon afin d'identifier le matériau présentant la plus haute efficacité potentielle.

6. Procédé de détection de l'efficacité potentielle d'une pluralité de matériaux photovoltaïques aptes à un traitement en solution, le procédé comprend les étapes suivantes consistant à:

réaliser une pluralité d'échantillons du matériau photovoltaïque ayant le même rapport du composant donneur et accepteur et étant traités avec différentes solutions, et
utiliser le procédé de l'une des revendications 1 à 4 pour déterminer le facteur de qualité $FOM_{PL}$ de chaque échantillon afin d'identifier le matériau présentant la plus haute efficacité potentielle.

7. Procédé de détection de l'efficacité potentielle d'une pluralité de matériaux photovoltaïques aptes à un traitement en solution, le procédé comprend les étapes suivantes consistant à:

réaliser une pluralité d'échantillons du matériau photovoltaïque ayant le même rapport du composant donneur et accepteur, en ce que le composant donneur ou accepteur est varié, et les échantillons étant traités avec la même solution, et
utiliser le procédé de l'une des revendications 1 à 4 pour déterminer le facteur de qualité $FOM_{PL}$ de chaque échantillon afin d'identifier le matériau présentant la plus haute efficacité potentielle.

8. Procédé selon l'une des revendications 5 à 7, en ce que la préparation d'au moins un premier ou second échantillon est effectuée automatiquement par un robot.

9. Procédé selon l'une des revendications 5 à 8, en ce que les premiers et/ou seconds échantillons sont automatiquement chargés dans et déchargés d'un dispositif pour réaliser des spectres de luminescence.

10. Procédé selon l'une des revendications 5 à 9, en ce que les spectres de photoluminescence sont automatiquement traités par ordinateur pour produire le facteur de qualité $FOM_{PL}$.

Fig. 1

Fig. 2

Fig. 3

Fig. 4

Fig. 5

Fig. 6

Fig. 7

Fig. 8

Fig. 9

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- Empirically based device modeling of bulk hetero-junction organic photovoltaics. **PIERRE ADRIEN et al.** Journal of Applied Physics. American Institute of Physics, 21 April 2013, vol. 113, 154506-154506

- **WENJIN YUE et al.** CuInS2 quantum dots synthesized by a solvothermal route and their application as effective electron acceptors for hybrid solar cells. *Journal of Materials Chemistry,* 01 January 2010, vol. 20 (35), 7570